# EUROPÄISCHE PATENTSCHRIFT

(11) **EP 0 835 048 B1**
(45) Veröffentlichungstag und Bekanntmachung des Hinweises auf die Patenterteilung: **05.12.2001**
(21) Anmeldenummer: 97116937.0
(22) Anmeldetag: 30.09.1997
(51) Int. Cl.: H05K 9/00

(54) **Mehrkanalsystem-Gehäuse**
Multiple-channel system - Housing
Système à canaux multiples - Boîtier

(30) Priorität: 05.10.1996 DE 29617342 U
(43) Veröffentlichungstag der Anmeldung: 08.04.1998
(73) Patentinhaber: Bodenseewerk Gerätetechnik GmbH, 88662 Überlingen (DE)
(72) Erfinder: Kummle, Wolfgang, 88682 Salem-Beuren (DE); Messmer, Helmut, 78269 Volkertshausen (DE)
(74) Vertreter: Weisse, Jürgen, Dipl.-Phys.

(56) Entgegenhaltungen:
- EP-A- 0 404 223
- EP-A- 0 579 346
- US-A- 4 370 700
- US-A- 5 504 659
- CROKE S ET AL: "MORE ELECTRIC INITIATIVE - POWER-BY-WIRE ACTUATION ALTERNATIVES" PROCEEDINGS OF THE NATIONAL AEROSPACE AND ELECTRONICS CONFERENCE (NAECON), DAYTON, MAY 23 - 27, 1994, Bd. VOL. 2, 23.Mai 1994, INSTITUTE OF ELECTRICAL AND ELECTRONICS ENGINEERS, Seiten 1338-1346, XP000510809

## Beschreibung

Die Erfindung betrifft ein Gehäuse für elektronische Komponenten nach dem Oberbegriff des Anspruchs 1.

Viele elektronische Steuerungen und Regelungen werden heute redundant eingesetzt, d.h. es werden mehrere Steuer- und Regelkreise gleichzeitig für den gleichen Zweck eingesetzt, so daß ein Ausfall eines der Systeme nicht unbedingt zum Ausfall der zu steuernden oder zu regelnden Vorrichtung führt. Die elektronischen Komponenten können also beispielsweise die eines zweikanaligen Triebwerksreglers sein.

Im allgemeinen bestehen solche Gehäuse aus einem kastenförmigen Körper mit einem einzigen Deckel. Die elektronischen Komponenten sind meistens auf Leiterplatten untergebracht, welche in sog. Sandwish-Technik übereinander in dem Gehäuse angeordnet sind. Bei defekten Komponenten muß in der Regel einige Komponenten oder Leiterplatten erst entfernt werden, um Zugang zu der defekten Stelle zu erhalten.

Durch die US-A-4370700 ist ein Gehäuse für elektronische Komponenten bekannt. das Gehäuse besteht aus einem Grundkörper mit einem planen Platte und einer Mehrzahl von zu der Platte senkrechten Wandungen zu beiden Seiten der Platte. Parallel mit der planen Platte sind zwei Leiterplatten an dem Gehäuse befestigt. Die Leiterplatten liegen an Enden der Wandungen so an, daß die Wandungen abgeschirmte Räume für an den Leiterplatten vorgesehenen elektronische Komponenten bilden. Das Gehäuse ist durch zwei Abdeckungen geschlossen, welche an äußeren Wandungen der planen Platte befestigt sind.

Der Erfindung liegt die Aufgabe zugrunde, ein Gehäuse der eingangs genannten Art zu schaffen, welche eine einfache Handhabbarkeit der elektronischen Komponenten gestattet.

Der Erfindung liegt weiterhin die Aufgabe zugrunde, die notwendigen mechanischen Komponenten bei einem Gehäuse der eingangs genannten Art zu reduzieren.

Erfindungsgemäß wird diese Aufgabe durch die im kennzeichnenden Teil des Anspruchs 1 aufgeführten Merkmale gelöst.

Dadurch ist der Zugang zu den elektronischen Komponenten der jeweiligen Kanäle gestattet, ohne daß Komponenten der anderen Kanäle entfernt werden müssen.

Je nach Anzahl der gegeneinander elektrisch abgeschirmten Teile des Gehäuses können eine oder mehrere elektrische Abschirmungen vorhanden sein.

Durch die besondere Ausbildung mindestens einer der Abdeckungen, bei welcher elektronische Komponenten in der Abdeckung unterbringbar sind, erhält man, wenn die elektronischen Komponenten auf Leiterplatten angeordnet sind, durch Abnehmen einer solchen Abdeckung Zugang zu zwei Ebenen von Leiterplatten, nämlich eine in der Abdeckung selbst und eine in dem zugehörigen Teil des Gehäuserahmens. Es können auch mehrere oder alle Abdeckungen in dieser Art gestaltet sein.

Das Gehäuse kann in zusammengebautem Zustand eine allgemein rechteckige Grundform besitzen und der Gehäuserahmen kann zwei diametral gegenüberliegenden, in entgegengesetzten Richtungen hochstehenden Vorsprünge aufweisen, wobei je eine Abdeckung an den Vorsprüngen anliegen kann. Diese Vorsprünge können abgeschirmte Teile des Gehäuserahmens bilden und durch Abdeckungen abdeckbar sein, welche ebenfalls elektronische Komponenten enthalten können. Es ist dann möglich, Leiterplatten sowohl waagerecht als auch senkrecht in dem Gehäuse anzuordnen. Man erhält ein sehr kompaktes Gehäuse, in welchem sehr viele direkt zugänglichen Leiterplatten untergebracht werden können.

Eine oder mehrere der Abdeckungen können mit Steckern versehen sein. Dies ist beispielsweise dann sehr vorteilhaft, wenn in der entsprechenden Abdeckung bzw. in den durch diese Abdeckung abgedeckten Teil des Gehäuserahmens Leiterplatten mit elektronischen Komponenten angeordnet sind, welche der Kommunikation mit der Außenwelt dienen.

Der Gehäuserahmen und die darin vorgesehenen Abschirmungen können einstückig ausgebildet sein. Dadurch wird die Anzahl der mechanischen Komponenten des Gehäuses reduziert. Die Herstellung des Gehäuses wird vereinfacht, da der Gehäuserahmen in einem Arbeitsschritt beispielsweise durch Fräsen hergestellt werden kann.

Ein Ausführungsbeispiel der Erfindung ist nachstehend unter Bezugnahme auf die zugehörigen Zeichnungen näher erläutert.
- Fig. 1: ist eine sehr schematische Darstellung und zeigt ein Ausführungsbeispiel des erfindungsgemäßen Gehäuses für ein Zweikanalsystem in Seitenansicht.
- Fig.2: zeigt das Gehäuse von Fig.1 in einer detaillierteren Schnittdarstellung.

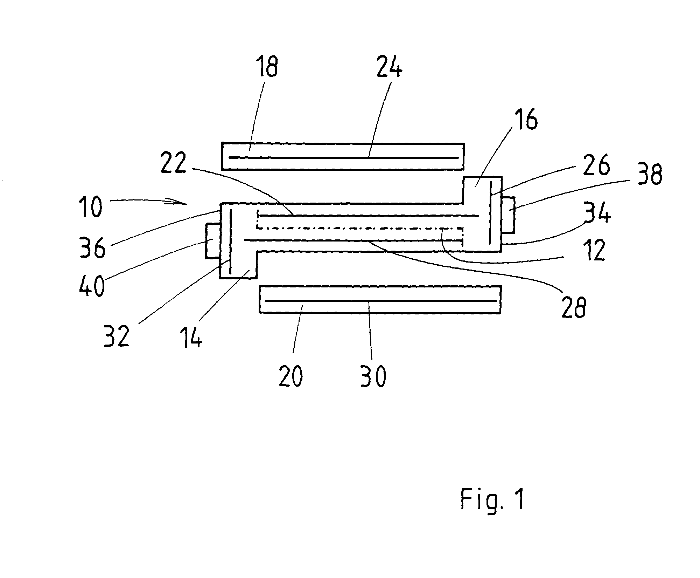

In den Figuren ist ein Ausführungsbeispiel des erfindungsgemäßen Gehäuses dargestellt, das als Träger für zwei identische Regeleinheiten (Kanäle) zur Triebwerksregelung dient. Mit 10 ist ein einstückig ausgebildeter Gehäuserahmen bezeichnet. Der Gehäuserahmen 10 ist durch eine als Abschirmung und Kanaltrennlinie dienende (in Fig.1 gestrichelt angedeutete) Trennwand 12 in zwei Teile unterteilt.

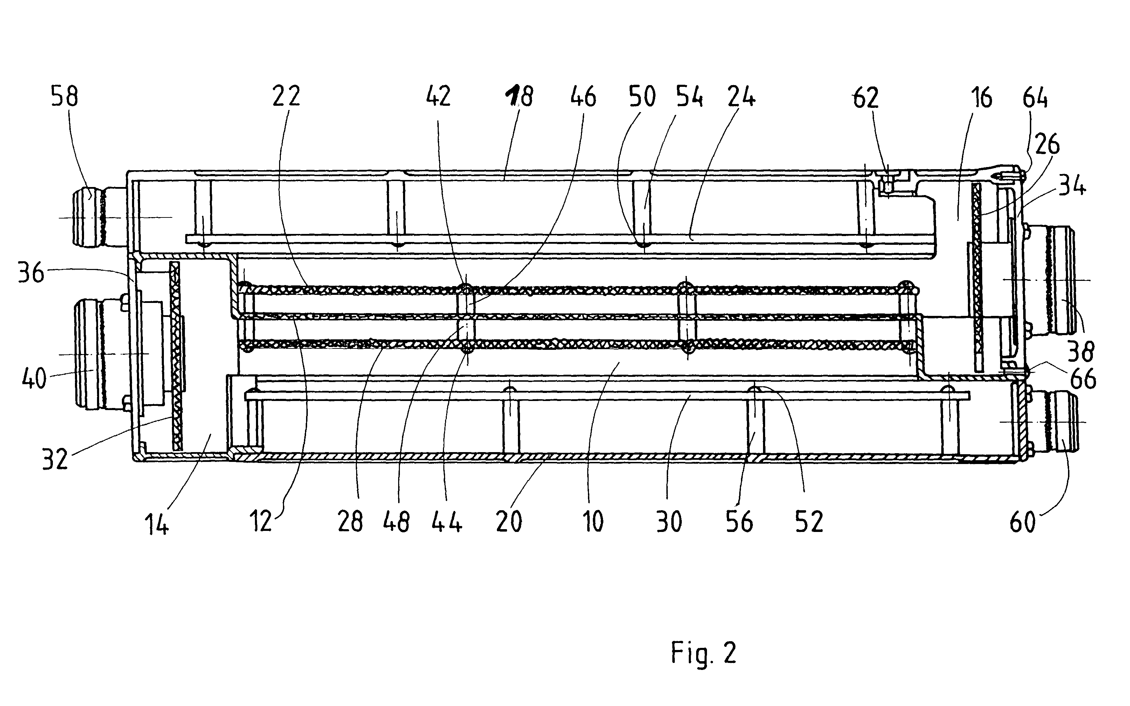

Der Gehäuserahmen 10 ist allgemein Z-förmig ausgebildet. Das in den Figuren linke Ende des Gehäuserahmens 10 ersteckt sich mit einem ersten Vorsprung 14 nach unten. Das in den Figuren rechte Ende des Gehäuserahmens 10 ersteckt sich mit einem zweiten Vorsprung 16 nach oben. Mit 18 bzw. 20 ist eine erste bzw. eine zweite Abdeckung des Gehäuses bezeichnet. In der Darstellung der Fig.1 ist die ersten und die zweiten Abdeckung 18 bzw. 20 von dem Gehäuserahmen 10 entfernt. In der Darstellung der Fig.2 ist die ersten und die zweiten Abdeckung 18 bzw. 20 an dem Gehäuserahmen 10 befestigt.

Der durch die Trennwand 12 von dem unteren Teil abgeschirmten oberen Teil des Gehäuserahmens 10 bildet zusammen mit dem rechten Vorsprung 16 und der ersten Abdeckung 18 die Aufnahme für die dem ersten Kanal zugeordneten elektronischen Komponenten. In dem dargestellten Ausführungsbeispiel handelt es sich dabei um drei Leiterplatten, nämlich eine in dem Gehäuserahmen 10 angeordnete, erste Hauptleiterplatte 22, eine in der ersten Abdeckung 18 angeordnete, zweite Hauptleiterplatte 24 und eine in dem Vorsprung 16 angeordnete Steckerleiterplatte 26. Entsprechend bildet der durch die Trennwand 12 von dem oberen Teil abgeschirmten unteren Teil des Gehäuserahmens 10 zusammen mit dem linken Vorsprung 14 und der zweiten Abdeckung 20 die Aufnahme für die dem zweiten Kanal zugeordneten elektronischen Komponenten. In dem dargestellten Ausführungsbeispiel handelt es sich dabei ebenfalls um drei Leiterplatten, nämlich eine in dem Gehäuserahmen 10 angeordnete, erste Hauptleiterplatte 28, eine in der zweiten Abdeckung 20 angeordnete, zweite Hauptleiterplatte 30 und eine in dem Vorsprung 14 angeordnete Steckerleiterplatte 32. Die Steckerleiterplatten 26 und 32 dienen der elektrischen Anbindung von Steckern zur Außenwelt des Gehäuses.

Um den Zugang zu den Steckerleiterplatten 26 bzw. 32 zu erleichtern, sind die Vorsprünge 16 bzw. 14 seitlich mit einer abnehmbaren dritten bzw. vierten Abdeckung 34 bzw. 36 versehen. In der dritten bzw. vierten Abdeckung 34 bzw. 36 sind Stecker 38 bzw. 40 eingearbeitet.

In der in Fig.2 gezeigten detaillierteren Darstellung des Ausführungsbeispiels erkennt man, daß die beiden in dem Gehäuserahmen 10 angeordneten, ersten Hauptleiterplatten 22 und 28 über Schrauben 42 bzw. 44 und isolierenden Abstandsstücke 46 bzw. 48 an jeweils einer Seite direkt an der Trennwand 12 befestigt sind. In der Fig.2 sind zu jeder der beiden Hauptleiterplatten 22 und 28 je vier solche Schrauben und Abstandsstücke dargestellt. Die beiden in den Abdeckungen 18 bzw. 20 angeordneten, zweiten Hauptleiterplatten 24 bzw. 30 sind ebenfalls über Schrauben 50 bzw. 52 und isolierenden Abstandsstücke 54 bzw. 56 direkt an der Innenseite der jeweiligen Abdeckung 18 bzw. 20 befestigt. In der Fig.2 sind zu jeder der beiden Hauptleiterplatten 24 und 30 je vier solche Schrauben und Abstandsstücke dargestellt.

In der Fig.2 erkennt man weiterhin, daß die erste und die zweite Abdeckung 18 bzw. 20 mit seitlichen Steckern 58 bzw. 60 versehen sind.

Die Abdeckungen 18, 20, 34 und 36 sind an dem Gehäuserahmen durch mehrere Schrauben befestigbar, von welchen in der Fig.2 nur eine Schraube 62 der ersten Abdeckung 18 und zwei Schrauben 64 und 66 der dritten Abdeckung 34 sichtbar sind. Es sei aber ausdrücklich erwähnt, daß auch jede andere lösbare Verbindnungsmöglichkeit denkbar ist.

In dem dargestellten Ausführungsbeispiel des erfindungsgemäßen Gehäuses ist sowohl der Gehäuserahmen 10 als auch das Gehäuse im zusammengebauten Zustand diametralsymmetrisch, d.h. die Form des Gehäuses bzw. des Gehäuserahmens 10 geht nach jeweils einer 180°-Drehung um eine in den Figuren vertikale und um eine in den Figuren horizontale Achse in sich selbst über. Die beiden Abdeckungen 18 und 20 und die beiden Abdeckungen 34 und 36 sind jeweils identisch ausgeführt. Diese Symmetrie des Gehäuserahmens 10 und die identische Ausführung der Abdeckungen 18 und 20 bzw. 34 und 36 ermöglicht eine sehr einfache Herstellung des Gehäuses.

Das erfindungsgemäße Gehäuse ermöglicht durch einfaches Abnehmen einer der Abdeckungen einen sehr einfachen und direkten Zugang zu den jeweiligen Leiterplatten. Eine einfache Handhabbarkeit bei Fertigung, Test und Reparatur der elektronischen Einheiten ist gegeben.

Das Gehäuse und die Befestigungen der Abdeckungen sind so ausgelegt, daß auch allgemeine technische Anforderungen wie Stabilität des Gehäuses, Schutz der innenliegenden elektrischen und elektronsichen Komponenten gegen Umwelteinflüsse, Kanaltrennung, Wärmehaushalt etc. berücksichtigt werden. Dies ist an sich bekannt und daher hier nicht im einzelnen beschrieben.

## Patentansprüche

1. Gehäuse für elektronische Komponenten, enthaltend
(a) ein Gehäuserahmen (10), welcher durch elektrische Abschirmungen (12) in zwei oder mehrere untereinander elektrisch abgeschirmte Teile unterteilt ist, und
(b) mindestens zwei an dem Gehäuserahmen (10) lösbar befestigbaren Abdeckungen (18,20,34,36), welche Zugang zu den elektrisch abgeschirmt unterteilten Teilen des Gehäuserahmens (10) gestatten,
**dadurch gekennzeichnet, daß**
(c) die elektronischen Komponenten für Zwei- oder Mehrkanalsysteme vorgesehen sind, wobei die jeweils einem Kanal zugeordneten elektronischen Komponenten (22,24,26;28,30,32) in jeweils einem der elektrisch abgeschirmten Teile des Gehäuses angeordnet sind, und
(d) mindestens eine der Abdeckungen (18;20) so ausgebildet ist, daß elektronische Komponenten (24;30) in der Abdeckung (18;20) unterbringbar sind.

2. Gehäuse nach Anspruch 1, **dadurch gekennzeichnet, daß** das Gehäuse in zusammengebautem Zustand eine allgemein rechteckige Grundform besitzt und der Gehäuserahmen (10) zwei diametral gegenüberliegenden, in entgegengesetzten Richtungen hochstehenden Vorsprünge (14,16) aufweist, wobei je eine Abdeckung (18;20) an den Vorsprüngen (14;16) anliegen.

3. Gehäuse nach Anspruch 1 oder 2, **dadurch gekennzeichnet, daß** eine oder mehrere der Abdeckungen (18,20,34,36) mit Steckern (38,40,58,60) versehen sind.

4. Gehäuse nach einem der Ansprüche 1 bis 3, **dadurch gekennzeichnet, daß** der Gehäuserahmen (10) und die darin vorgesehenen Abschirmungen (12) einstückig ausgebildet sind.

## Claims

1. Housing for electronic components, comprising
(a) a housing frame (10) which is divided into two or more mutually electrically shielded parts through electrical shields (12), and
(b) at least two covers (18,20,34,36) adapted to be detachably attached to the housing frame (10) and allowing access to the electrically shielded and divided parts of the housing frame (10),
**characterized in that**
(c) the electronic components are provided for two- or multi-channel systems, the electronic components (22,24,26;28,30,32) associated with one and the same channel being arranged in one and the same of the electrical shielded parts of the housing, and
(d) at least one of the covers (18;20) being designed to accommodate electronic components (24;30) in the cover (18;20).

2. Housing as set forth in claim 1, **characterized in that** the housing has a generally rectangular basic form in assembled state and the housing frame (10) has two diametrically opposite projections (14,16) projecting in opposite directions, the covers (18;20) engaging the projections (14;16).

3. Housing as set forth in claim 1 or 2, **characterized in that** one or several of the covers (18,20,34,36) are provided with connectors (38,40,58,60).

4. Housing as set forth in anyone of the claims 1 to 3, **characterized in that** the housing frame (10) and the shields (12) provided therein are integral parts.

## Revendications

1. Boîtier pour composants électroniques, comprenant
(a) un cadre de boîtier (10) subdivisé en deux ou plusieurs parties protégées les unes des autres contre les parasites par des écrans antiparasite (12),
(b) au moins deux caches (18,20,34,36) susceptibles d'être fixés au cadre de boîtier (10) de façon susceptible d'être détachés qui permettent d'accéder aux parties du cadre de boîtier (10) subdivisées et sans parasite,
**caractérisé par le fait que**
(c) les composants électroniques sont prévus pour des systèmes à deux ou plusieurs canaux, les composants électroniques (22,24,26;28,30,32) associés chaque fois à un canal étant disposés à chaque fois dans l'une des parties sans parasite du boîtier, et
(d) au moins l'un des caches (18;20) sont configurés de telle façon que les composants électroniques (24;30) sont susceptibles d'être logés dans le cache (18;20).

2. Boîtier selon la revendication 1, **caractérisé par le fait que** le boîtier possède une forme de base généralement rectangulaire lorsqu'il est assemblé et que le cadre de boîtier (10) présente deux saillies (14,16) diamétralement opposées et s'élevant dans deux directions opposées, chacun des caches (18;20) s'appuyant contre les saillies (14;16).

3. Boîtier selon la revendication 1 ou 2, **caractérisé par le fait que** un ou plusieurs caches (18,20,34,36) sont pourvus de connecteurs (38,40,58,60).

4. Boîtier selon l'une des revendications 1 à 3,
**caractérisé par le fait que** le cadre de boîtier (10) et les écrans (12) prévus à l'intérieur sont configurés en une seule pièce.
